# EUROPÄISCHE PATENTANMELDUNG

(11) **EP 1 411 549 A1**
(43) Veröffentlichungstag der Anmeldung: **21.04.2004**
(21) Anmeldenummer: 03022419.0
(22) Anmeldetag: 07.10.2003
(51) Int. Cl.: H01L 23/373

(54) **Leistungshalbleitermodul mit elektrisch leitenden Kohlenstoffnanoröhrchen**

(30) Priorität: 18.10.2002 DE 10248644
(71) Anmelder: Semikron Elektronik GmbH Patentabteilung, 90253 Nürnberg (DE)
(72) Erfinder: Heilbronner, Heinrich, Dr., 90547 Stein (DE)

(57) **Zusammenfassung**

Es wird ein Leistungshalbleitermodul, insbesondere ein Stromrichtermodul, mit Grundplatte (1) oder zur direkten Montage auf einem Kühlkörper (1), vorgestellt. Das Leistungshalbleitermodul besteht aus einem Gehäuse, mindestens einem Leistungshalbleiterbauelement (4), sowie mindestens einem isolierenden Substrat (2), auf dessen erster Oberfläche eine metallische Schicht (3) angeordnet ist. Zur thermischen und teilweise zur elektrischen Kontaktierung werden Kohlenstoffnanoröhrchen (5,6,8) verwendet, einerseits zur Kontaktierung des Leistungshalbleiterbauelements (4) mit der metallischen Schicht (3) und andererseits zur Verbindung des Substrats (2) mit dem Kühlkörper (1).

## Beschreibung

Die Erfindung beschreibt ein Leistungshalbleitermodul, insbesondere ein Stromrichtermodul, mit Grundplatte oder zur direkten Montage auf einem Kühlkörper mit aktiven und / oder passiven Bauelementen. Derartige Leistungshalbleitermodule sind mehrfach aus der Literatur bekannt. Bei der Erhöhung der Leistungsfähigkeit, speziell durch den Einsatz modemer Leistungshalbleiterbauelemente mit einem erhöhten Kühlbedarf sind veränderte Methoden der Aufbautechnologien für die einzelnen Bestandteile eine zwingende Voraussetzung.

Modeme Leistungshalbleitermodule, die Ausgangspunkt dieser Erfindung sind, sind grundplattenlose Module, wie beispielhaft in der DE 199 03 875 C2 beschrieben, bestehend aus
- einem Gehäuse;
- einem keramischen Substrat mit darauf angeordneten schaltungsgerecht ausgeführten metallischen Kaschierungen, wie sie z.B. nach dem DCB (direct copper bonding)-Verfahren hergestellt werden;
- auf diesem Substrat mittels Löttechnik stoffschlüssig aufgebrachten Bauelementen, wie beispielhaft Dioden, Transistoren, Widerständen oder Sensoren;
- Bondverbindungen zur Verbindung der strukturierten Seite der Bauelemente mit weiteren Bauelementen, dem Substrat und / oder nach außen führenden Anschlusselementen.
- Einer vorzugsweise aus Silikonkautschuk bestehenden Vergussmasse zur Isolation der einzelnen Bauelemente zueinander.

Sehr vorteilhaft hat sich für derartige Leistungshalbleitermodule die Aufbautechnologie mit Druckkontakt zur thermischen Kontaktierung des Moduls auf einem Kühlkörper erwiesen. Es hat sich gezeigt, dass sich insbesondere großflächige Lötverbindungen nur sehr schwer qualitätsgerecht beherrschen lassen, worunter die Zuverlässigkeit sowie die Lebensdauer der Leistungshalbleitermodule leiden.

Der Druckaufbau in derartigen druckkontaktierten Leistungshalbleitermodulen wird vorteilhafterweise mittels einer mechanisch stabilen Druckplatte erzielt. Je nach weiterer Ausgestaltung kann der erzeugte Druck direkt mittels spezieller Ausgestaltungen der Druckplatte, wie beispielhaft in der DE 196 48 562 C2 gezeigt, oder mittels eines elastischen Druckspeichers nach der DE 199 03 875 C2, auf das Substrat übertragen werden.

Bei derartigen druckkontaktierten Leistungshalbleitermodulen befindet sich zum vollflächigen thermischen Kontakt und damit zum Ausgleich von Unebenheiten auf dem Kühlkörper und / oder auf der Substratunterseite zwischen dem Leistungshalbleitermodul und dem Kühlkörper ein wärmeleitendes Medium.

Den Leistungshalbleitermodulen nach DE 196 48 562 C2 oder DE 199 03 875 C2 sowie auch den weiteren nach dem Stand der Technik bekannten Leistungshalbleitermodulen mit Grundplatte oder zur direkten Montage auf einem Kühlkörper haftet der Nachteil an, dass die Wärmeabführung zu einer Wärmesenke beispielhaft einem Kühlkörper mit einem hohen thermischen Widerstand behaftet ist. Dieser ist umso größer je mehr Grenzflächen sich zwischen dem die Wärme erzeugenden Leistungshalbleiterbauelement und der Wärmesenke befinden. Flexible wärmeleitende Schichten, wie beispielsweise Wärmeleitpaste, weisen gegenüber Metallen einen deutlich höheren Wärmewiderstand auf. Ein effizientes Ableiten der Wärme aus einem Leistungshalbleitermodul zu einer Wärmesenke ist daher ein wesentlicher Bestandteil hoch effizienter kompakter Aufbautopologien.

Ein weiterer Nachteil von Leistungshalbleitermodulen mit Grundplatte oder zur direkten Montage auf einem Kühlkörper nach dem Stand der Technik ist, dass die eingesetzten modernen Leistungshalbleiterbauelemente pro Chipfläche eine höhere Stromtragfähigkeit aufweisen und auch eine höhere Abwärme pro Flächeneinheit produzieren. Die Verbindung zwischen einem vorteilhafterweise metallkaschierten Substrat und dem Leistungshalbleiterbauelement ist bereits eine beschränkende Größe für die Leistungsfähigkeit eines Leistungshalbleitermoduls. Die im Leistungshalbleiterbauelement entstehende Wärme kann derzeit noch über die bestehenden Verbindungstechniken, meist Lötverbindungen, abgeführt werden. Bei zukünftigen Chipgenerationen wird die thermische Leitung der Verbindung zwischen dem Leistungshalbleiterbauelement und dem Substrat als noch stärker leistungsbeschränkende Einflussgröße wirken. Ebenso sind die genannten Verbindungen an der Grenze ihrer Stromtragfähigkeit. Auch hier wird die elektrische Verbindung zwischen dem Leistungshalbleiterbauelement und dem Substrat die Leistungsfähigkeit eines Leistungshalbleitermoduls bestimmen.

Die vorliegende Erfindung hat die Aufgabe ein Leistungshalbleitermodul vorzustellen, bei dem die elektrisch und thermisch leitende Verbindung zwischen mindestens einem Leistungshalbleiterbauelement und dem Substrat und / oder die thermisch leitende Verbindung zu einer Wärmesenke einen verringerten thermischen und wenn notwendig auch elektrischen Widerstand aufweist.

Die Aufgabe wird gelöst durch die Maßnahmen des Anspruchs 1. Weitere vorteilhafte Ausgestaltungen sind in den Unteransprüchen genannt.

Bekannt sind aus vielfältigen Forschungsarbeiten und beispielhaft aus der DE 101 03 340 A1 Kohlenstoffnanoröhrchen als ein elektrisch und thermisch hoch leitfähiges Material. Bekannt ist weiterhin, dass derartige Kohlenstoffnanoröhrchen eine Vorzugsrichtung in Richtung des Röhrenverlaufs aufweisen. In dieser Vorzugsrichtung weisen diese Kohlenstoffnanoröhrchen bei geeigneter Ausgestaltung sowohl einen geringeren thermischen als auch einen geringeren elektrischen Widerstand im Vergleich zu Metallen auf.

Der Grundgedanke der Erfindung liegt nun im Einsatz derartiger Kohlenstoffnanoröhrchen als thermisch und / oder thermisch und elektrisch leitende Komponente innerhalb eines Leistungshalbleitermoduls und / oder von einem Leistungshalbleitermodul zu einem Kühlkörper.

Das erfinderische Leistungshalbleitermodul mit einer Grundplatte oder zur direkten Montage auf einem Kühlkörper besteht aus einem Gehäuse, mindestens einem elektrisch und thermisch zu kontaktierenden Leistungshalbleiterbauelement sowie mindestens einem isolierenden Substrat.

Auf der ersten der Grundplatte oder dem Kühlkörper abgewandten Oberfläche des Substrates ist eine metallische Schicht angeordnet, die vorzugsweise schaltungsgerecht strukturiert ist und worauf mindestens ein Leistungshalbleiterbauelement angeordnet ist. Als elektrisch und thermisch leitfähige Verbindung zwischen dem Leistungshalbleiterbauelement und der metallischen Schicht ist eine Schicht aus im wesentlichen orthogonal zur Substratebenen verlaufenden Kohlenstoffnanoröhrchen angeordnet.

Alternativ oder ergänzend weist das erfinderische Leistungshalbleitermodul eine weitere Schicht aus Kohlenstoffnanoröhrchen auf, welche zwischen dem Substrat und einer Wärmesenke, einem Kühlkörper oder einer Grundplatte angeordnet ist. Diese Schicht weist eine hohe thermische Leitfähigkeit auf.

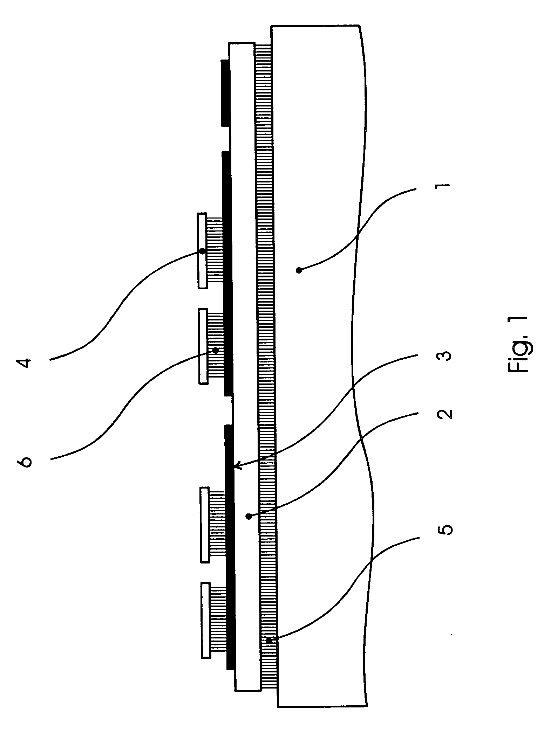

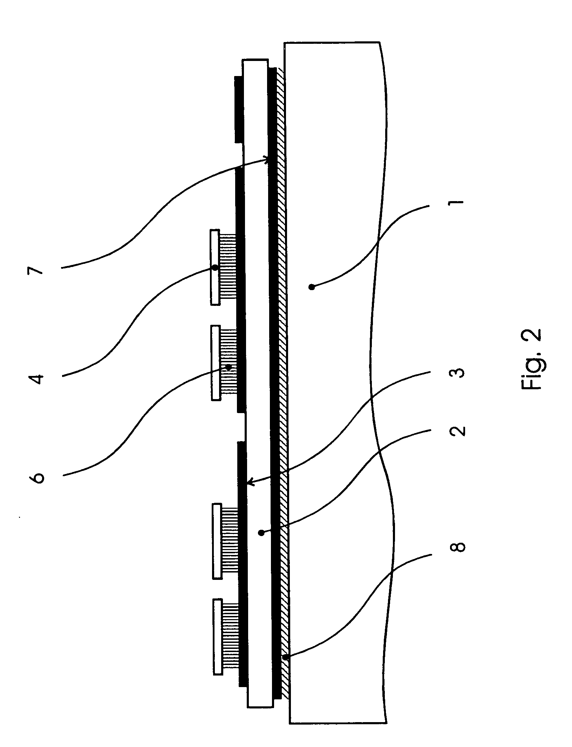

Spezielle Ausgestaltungen der erfinderischen Lösungen werden anhand der Fig. 1 und 2 erläutert. Auf die Darstellung eines Gehäuses sowie auf Verbindungen nach dem Stand der Technik zwischen den Oberseiten der Bauelemente und den metallischen Schichten sowie zu weiteren Anschlusselementen wird aus Gründen der Übersichtlichkeit verzichtet.

In den Figuren ist der Querschnitt durch ein die erfinderischen Merkmale aufweisendes Leistungshalbleitermodul in einem Aufbau mit einem Kühlkörper (1) bzw. einer Grundplatte (1) gezeigt. Daher wird im Folgenden Grundplatte und Kühlkörper synonym verwendet.

Fig. 1 zeigt einen Kühlkörper (1), der mittels einer auf diesem aufgewachsenen Schicht aus im wesentlichen orthogonal zur Kühlkörperoberfläche verlaufenden Kohlenstoffnanoröhrchen (5) mit dem isolierenden Substrat (2) thermisch leitend verbunden ist. Die Schicht aus Kohlenstoffnanoröhrchen kann ebenso auf dem Substrat (2) aufgewachsen sein. Hierzu ist auf dem Substrat auf dessen dem Kühlkörper (1) zugewandten Seite vorteilhafterweise eine metallische Schicht (8, in Fig. 2) angeordnet. Diese Schicht (8) kann ebenso wie die metallische Schicht (3) auf der dem Kühlkörper (1) abgewandeten Seite des Substrates (2) beispielhaft mittels des bekannten DCB- Verfahrens aufgebracht sein. Es kann vorteilhaft sein, wenn zwischen der so entstandenen Kupferschicht und der Schicht aus Kohlenstoffnanoröhrchen noch eine weitere im Vergleich zur Kupferschicht dünne Schicht eines anderen Metalls, vorzugsweise Nickel, als Haftvermittler für die Kohlenstoffnanoröhrchen angeordnet ist.

Die Kohlenstoffnanoröhrchen werden nach einem bekannte Verfahren beispielhaft dem der DE 101 03 340 A1 auf die entsprechenden Oberflächen aufgebracht.

Auf der dem Kühlkörper (1) abgewandten Seite des Substrates (2) sind die Leistungshalbleiterbauelemente (4) angeordnet. Diese weisen auf ihrer dem Substrat (2) zugewandten Seite eine Schicht aus direkt auf dem Leistungshalbleiterbauelement (4) aufgewachsenen Kohlenstoffnanoröhrchen (6) auf.

Die sichere Kontaktierung der Leistungshalbleiterbauelemente (4) auf der metallischen Schicht (3) wird durch eine nicht gezeichnete Druckkontaktierung erreicht. Hierzu wird mittels eines geeigneten Druckelements auf die Oberseite des Leistungshalbleiterbauelements (4) gedrückt. Vorteilhafterweise kann auf diese Weise auch eine elektrische Kontaktierung erreicht werden. Eine derartige Kontaktierung ist beispielsweise aus der DE 101 29 170 A1 bekannt.

Das gesamte Leistungshalbleitermodul wird ebenfalls mittels Druckkontaktierung beispielsweise nach der DE 101 29 170 A1 auf den Kühlkörper (1) gedrückt und somit thermisch leitend mit diesem verbunden.

Eine weitere Ausgestaltung der thermisch leitenden Verbindung zwischen dem Substrat (2) und dem Kühlkörper (1) zeigt Fig. 2. Hierbei sind die Kohtenstoffnanoröhrchen nicht in einem Gesamtverbund wie oben beschrieben angeordnet, sondern als einzelne Röhrchen oder Gruppen von Röhrchen jeweils eingebettet in ein Bindemittel, beispielhaft einem Silikonöl AKF 1000 der Firma Wacker. Diese pastöse Mischung (8) ist in gleicher Weise zwischen dem Substrat (2) und dem Kühlkörper (1) angeordnet wie gängige Wärmeleitpasten nach dem Stand der Technik. Vorteilhaft an der erfinderischen Ausgestaltung ist die um mindestens 2 Größenordnungen geringere thermische Leitfähigkeit dieser pastösen Mischung im Vergleich zum Stand der Technik.

## Patentansprüche

1. Leistungshalbleitermodul mit Grundplatte (1) oder zur direkten Montage auf einem Kühlkörper (1) bestehend aus einem Gehäuse, mindestens einem Leistungshalbleiterbauelement (4) sowie mindestens einem isolierenden Substrat (2) auf dessen erster Oberfläche eine metallische Schicht (3) angeordnet ist, wobei
das mindestens eine Leistungshalbleiterbauelement (4) mittels einer Schicht aus im wesentlichen orthogonal zur Substratebenen verlaufenden Kohlenstoffnanoröhrchen (6) mit der metallischen Schicht (3) verbunden ist und / oder
das Substrat (2) mittels einer Schicht aus Kohlenstoffnanoröhrchen (5, 8) mit der Grundplatte (1) oder dem Kühlkörper (1) verbunden ist.

2. Leistungshalbleitermodul nach Anspruch 1 wobei
auf der zweiten Hauptfläche zwischen dem Substrat (2) und der Schicht aus Kohlenstoffnanoröhrchen (5, 8) eine weitere metallische Schicht (7) angeordnet ist.

3. Leistungshalbleitermodul nach Anspruch 1 wobei
mindestens ein Leistungshalbleiterbauelement (4) mit daran angeordneten Kohlenstoffnanoröhrchen mittels einer Druckkontaktierung stoffbündig auf dem Substrat (2) angeordnet ist.

4. Leistungshalbleitermodul nach Anspruch 1 wobei
das Leistungshalbleitermodul mittels einer Druckkontaktierung auf der Grundplatte (1) oder dem Kühlkörper (1) angeordnet ist.

5. Leistungshalbleitermodul nach Anspruch 1 wobei
die Kohlenstoffnanoröhrchen (6) direkt auf dem Leistungshalbleiterbauelement (4) angeordnet sind.

6. Leistungshalbleitermodul nach Anspruch 1 wobei
die Kohlenstoffnanoröhrchen (5, 6) auf mindestens einer metallischen Schicht (3, 7) des Substrates (2) angeordnet sind.

7. Leistungshalbleitermodul nach Anspruch 1 wobei
die Kohlenstoffnanoröhrchen (5) im wesentlichen orthogonal zur Substratebene angeordnet sind.

8. Leistungshalbleitermodul nach Anspruch 1 wobei
die Kohlenstoffnanoröhrchen zwischen dem Substrat (2) und der Grundplatte (1) oder dem Kühlkörper (1) in einer pastösen Mischung (8) aus Kohlenstoffnanoröhrchen und einem Bindemittel, beispielhaft einem Silikonöl, angeordnet sind.
